# EUROPEAN PATENT APPLICATION

(11) **EP 2 172 304 A1**
(43) Date of publication of application: **07.04.2010**
(21) Application number: 08778124.1
(22) Date of filing: 08.07.2008
(51) Int. Cl.: B24B 21/08, B24B 9/00, B24B 21/16, H01L 21/304

(54) **POLISHING APPARATUS**

(30) Priority: 11.07.2007 JP 2007181616
(71) Applicant: EBARA CORPORATION, Ohta-ku, Tokyo 144-8510 (JP)
(72) Inventor: TAKAHASHI, Tamami, Tokyo 144-8510 (JP); ITO, Kenya, Tokyo 144-8510 (JP); KUSA, Hiroaki, Tokyo 144-8510 (JP); SEKI, Masaya, Tokyo 144-8510 (JP)
(74) Representative: Carstens, Dirk Wilhelm
(86) International application number: PCT/JP2008/062653
(87) International publication number: WO 2009/008531

(57) **Abstract**

A polishing apparatus according to the present invention includes a polishing tape (41) having a polishing surface, a substrate holder configured to hold and rotate a substrate (W), a press pad (50) configured to press the polishing tape against a bevel portion of the substrate held by the substrate holder, and a polishing-tape feeding mechanism (45) configured to cause the polishing tape to travel in its longitudinal direction. The press pad (50) includes a pad body (53), a plate-shaped pressing section having a pressing surface (51a) for pressing the bevel portion of the substrate through the polishing tape and having a rear surface (51b) opposite to the pressing surface, and a plurality of coupling sections (52) coupling the pressing section to the pad body. A space (S) is formed between the rear surface of the pressing section and the pad body.

## Description

### Technical Field

The present invention relates to a polishing apparatus using a polishing tape, and more particularly to a polishing apparatus for polishing a bevel portion of a substrate, such as a semiconductor wafer.

### Background Art

From a viewpoint of improving a yield in semiconductor fabrications, management of a surface condition in a bevel portion of a semiconductor wafer has recently been drawing attention. Since a number of materials are deposited on a semiconductor wafer repeatedly to form multilayer structures, unwanted materials and damage are left on a bevel portion which is not used for actual products. As a conventional way of transporting and holding a wafer, it has been typically practiced to bring a holding member (e.g., a robot hand) into contact with a rear surface of a wafer. However, there is an increasing demand for maintaining cleanliness of the rear surface, as microfabrication technique of a device advances and a wafer having a diameter of 300 mm becomes mainstream. Therefore, it has been more common in recent years to transfer and hold a wafer by bringing a holding member into contact with only an edge of the wafer. Under such a background, the unwanted materials and damage, left on the bevel portion, are likely to come off the wafer during various processes and can adhere to a surface of a device. Such materials, attached to the device, can affect a yield in products.

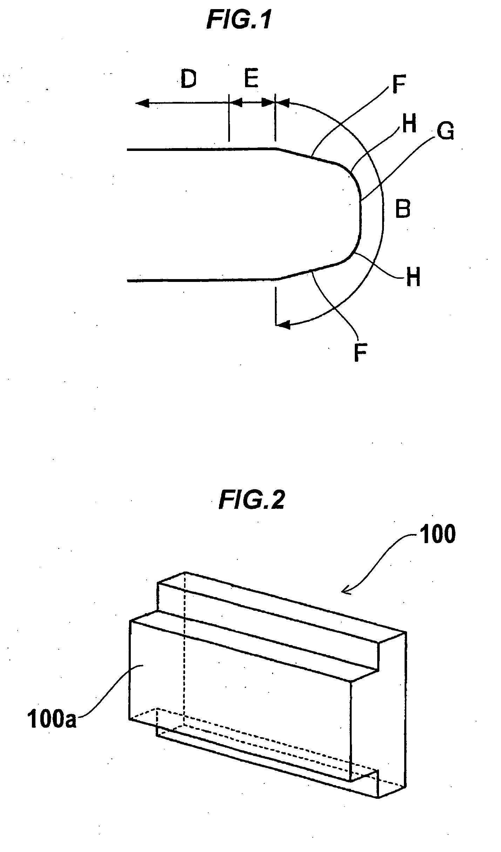

In this specification, a bevel portion is, as shown in FIG 1, a portion B where a cross section of a periphery of a substrate has a curvature. A flat portion indicated by a symbol D in FIG 1 is a region where devices are formed. A flat portion E extending outwardly from the device-formation region D by several millimeters is referred to as an edge portion, which is distinguished from the device-formation region D. That is, the bevel portion is a rounded section extending from the edge portion E to the rear surface of the substrate.

While a cross-sectional shape of the bevel portion varies widely depending on substrate manufacturers, the bevel portion generally includes, as shown in FIG. 1, a slope surface F adjacent to the edge portion E, an outermost vertical surface G, and a slope surface F adjacent to the rear surface. The slope surfaces F and the vertical surface G are connected to each other by smooth curved surfaces H.

A polishing apparatus using a polishing tape is known as a device for removing a film formed on the bevel portion of the substrate. This type of polishing apparatus has a press pad arranged at a rear side of the polishing tape and is configured to press a polishing surface of the polishing tape against the bevel portion of the substrate by the press pad to thereby polish the bevel portion.

FIG 2 is a perspective view showing a conventional press pad. As shown in FIG 2, a press pad 100 has a rectangular pressing surface 100a. This press pad 100 is disposed at the rear side of the polishing tape and presses the surface (i.e., the polishing surface) of the polishing tape against the bevel portion of the substrate with the pressing surface 100a. The press pad 100 is fabricated from rubber; sponge, or the like. For example, urethane rubber or silicon sponge with a hardness (e.g., 20 to 40 degrees) suitable for polishing is selected as a material of the press pad.

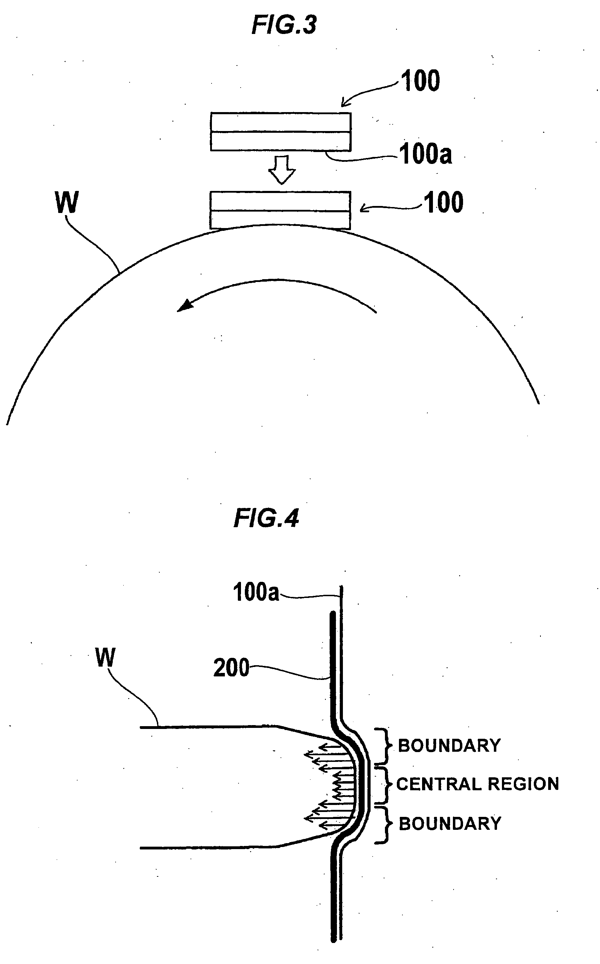

FIG 3 is a plan view showing the press pad when pressing a wafer and when not pressing the wafer. As shown in FIG 3, a wafer W to be polished has a disk shape. When the press pad presses the polishing tape (not shown) against the bevel portion of the wafer W, part of the pressing surface 100a of the press pad 100 is compressed as the result of contact with the wafer W Consequently, a contact area between the polishing tape and the wafer W is increased and a polishing speed per unit time is improved.

FIG 4 is a vertical cross-sectional view showing the press pad when pressing the polishing tape against the bevel portion of the wafer. As shown in FIG 4, during polishing, the pressing surface 100a of the press pad 100 is deformed along the bevel portion. Consequently, polishing pressure becomes high at boundaries between a region where the polishing tape 200 is in contact with the wafer W and regions where the polishing tape 200 is separated from the wafer W as indicated by arrows in FIG 4. Specifically, polishing pressure on the boundaries is high and polishing pressure on a central region located between these boundaries is low. This makes it difficult to polish the central region. In such a case, if polishing is performed for the purpose of completely removing a film or an organic substance (stain) on the central region, the boundaries are excessively polished.

### Disclosure of Invention

The present invention has been made in view of the above drawbacks. It is therefore an object of the present invention to provide a polishing apparatus capable of controlling a contact area in a lateral direction of a bevel portion of a substrate and a distribution of loads applied along a vertical direction of the bevel portion of the substrate.

In order to solve the above drawbacks, one aspect of the present invention is to provide a polishing apparatus including: a polishing tape having a polishing surface; a substrate holder configured to hold and rotate a substrate; a press pad configured to press the polishing tape against a bevel portion of the substrate held by the substrate holder; and a polishing-tape feeding mechanism configured to cause the polishing tape to travel in its longitudinal direction. The press pad includes a pad body, a plate-shaped pressing section having a pressing surface for pressing the bevel portion of the substrate through the polishing tape and having a rear surface opposite to the pressing surface, and a plurality of coupling sections coupling the pressing section to the pad body. A space is formed between the rear surface of the pressing section and the pad body.

In a preferred aspect of the present invention, the plurality of coupling sections are arranged along a circumferential direction of the substrate held by the substrate holder.

In a preferred aspect of the present invention, the plurality of coupling sections are connected to both sides of the pressing section.

In a preferred aspect of the present invention, the plurality of coupling sections are connected to the rear surface of the pressing section and located inwardly from both sides of the pressing section toward a center of the pressing section.

In a preferred aspect of the present invention, the rear surface of the pressing section has a plurality of grooves extending in a direction perpendicular to a surface of the substrate.

In a preferred aspect of the present invention, a plurality of reinforcing members, extending in a direction perpendicular to a surface of the substrate, are secured to the rear surface of the pressing section.

In a preferred aspect of the present invention, the rear surface of the pressing section has at least one recess extending in a circumferential direction of the substrate.

In a preferred aspect of the present invention, the pressing section has a shape such that a thickness thereof increases gradually from both sides of the pressing section toward a center thereof.

In a preferred aspect of the present invention, the pressing section is made from rigid plastic.

According to the present invention, since the pressing surface is not compressed greatly when contacting the bevel portion, high polishing pressure can be applied to the central region of the bevel portion. Therefore, the polishing tool can polish the central region of the bevel portion effectively without excessively polishing the boundaries at both sides of the central region of the bevel portion.

### Brief Description of Drawings

FIG. 1 is a cross-sectional view showing a periphery of a substrate;
FIG. 2 is a perspective view showing a conventional press pad;
FIG. 3 is a plan view showing the press pad when pressing a wafer and when not pressing the wafer;
FIG. 4 is a vertical cross-sectional view showing the press pad when pressing a polishing tape against a bevel portion of a wafer;
FIG. 5 is a plan view showing a polishing apparatus according to an embodiment of the present invention;
FIG. 6 is a cross-sectional view of the polishing apparatus shown in FIG 5;
FIG. 7 is a plan view showing chuck hands of a wafer chucking mechanism;
FIG. 8 is an enlarged view of a polishing head;
FIG. 9A is a perspective view showing a press pad incorporated in the polishing head shown in FIG 8;
FIG. 9B is a top view of the press pad shown in FIG 9A;
FIG. 10 is a plan view showing the press pad when pressing the wafer and when not pressing the wafer;
FIG. 11 is a vertical cross-sectional view showing the press pad when pressing a polishing tape against the bevel portion of the wafer;
FIG. 12 is a plan view showing another example of the press pad;
FIG. 13 is a plan view showing another example of the press pad;
FIG. 14 is a plan view showing another example of the press pad;
FIG. 15 is a plan view showing another example of the press pad;
FIG. 16A is a perspective view showing another example of the press pad;
FIG. 16B is a top view of the press pad shown in FIG 16A;
FIG. 16C is a plan view showing the press pad when pressing the wafer and when not pressing the wafer;
FIG. 17A is a perspective view showing another example of the press pad;
FIG 17B is a top view of the press pad shown in FIG. 17A;
FIG 17C is a plan view showing the press pad when pressing the wafer and when not pressing the wafer; and
FIG 18A through FIG. 18C are views each illustrating motion of the polishing head when polishing the bevel portion.

### Best Mode for Carrying Out the Invention

A polishing apparatus according to an embodiment of the present invention will be described below with reference to the drawings.

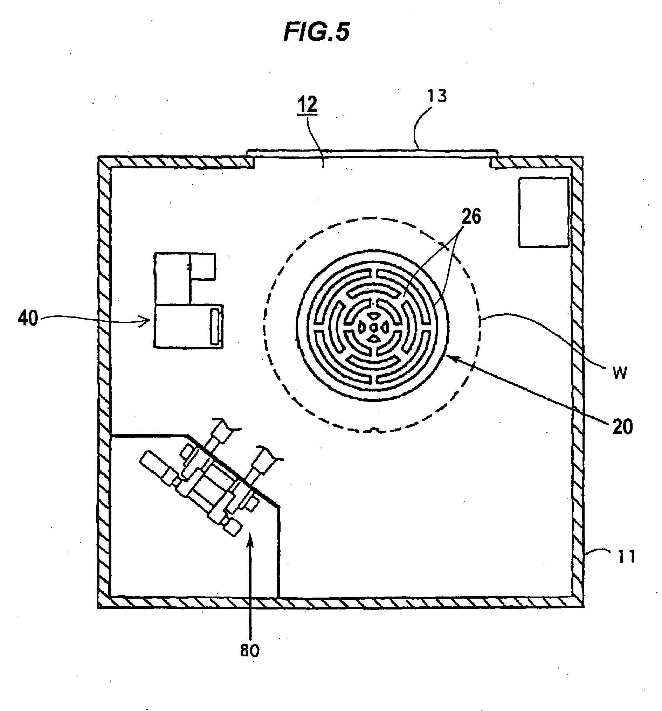

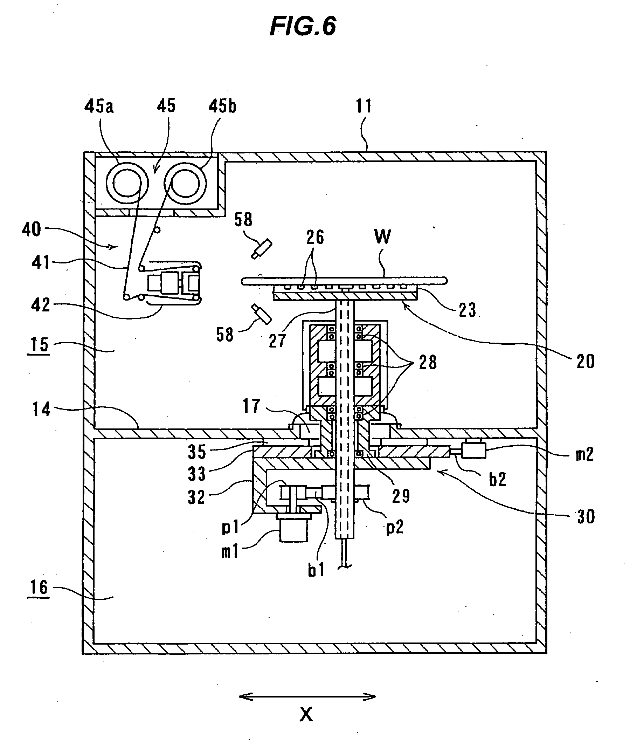

FIG 5 is a plan view showing a polishing apparatus according to the embodiment of the present invention. FIG. 6 is a cross-sectional view of the polishing apparatus shown in FIG 5.

As shown in FIG 5 and FIG 6, the polishing apparatus according to the present embodiment includes a wafer stage unit 20 having a wafer stage 23 for holding a wafer W, a stage moving mechanism 30 configured to move the wafer stage unit 20 in a direction parallel to an upper surface (wafer holding surface) of the wafer stage 23, and a bevel polishing unit 40 configured to polish a bevel portion of the wafer W held by the wafer stage 23.

The wafer stage unit 20, the stage moving mechanism 30, and the bevel polishing unit 40 are contained in a housing 11. The housing 11 is partitioned by a partition plate 14 into two spaces: an upper chamber (a polishing chamber) 15 and a lower chamber (a mechanical chamber) 16. The above-mentioned wafer stage 23 and the bevel polishing unit 40 are located in the upper chamber 15, and the stage moving mechanism 30 is located in the lower chamber 16. The upper chamber 15 has a side wall with an opening 12. This opening 12 is closed by a shutter 13 which is driven by an air cylinder (not shown).

The wafer W is transported into and from the housing 11 through the opening 12. Transporting of the wafer W is performed by a known wafer transporting mechanism (not shown), such as a transport robot hand.

An upper surface of the wafer stage 23 has a plurality of grooves 26. These grooves 26 communicate with a vacuum pump (not shown) via a vertically extending hollow shaft 27. When the vacuum pump is operated, vacuum is produced in the grooves 26, whereby the wafer W is held on the upper surface of the wafer stage 23. The hollow shaft 27 is rotatably supported by bearings 28, and further the hollow shaft 27 is coupled to a motor m1 via pulleys p1, p2 and a belt b1. With these configurations, the wafer W is rotated by the motor m1, with being held on the upper surface of the wafer stage 23.

The polishing apparatus further includes a wafer chucking mechanism 80 disposed in the housing 11. The wafer chucking mechanism 80 is configured to receive the wafer W, which has been transported into the housing 11 by the above-mentioned wafer transporting mechanism, and place the wafer W onto the wafer stage 23. Further, the wafer chucking mechanism 80 is configured to remove the wafer W from the wafer stage 23 and transport the wafer W to the above-mentioned wafer transporting mechanism. Only part of the wafer chucking mechanism 80 is shown in FIG 5.

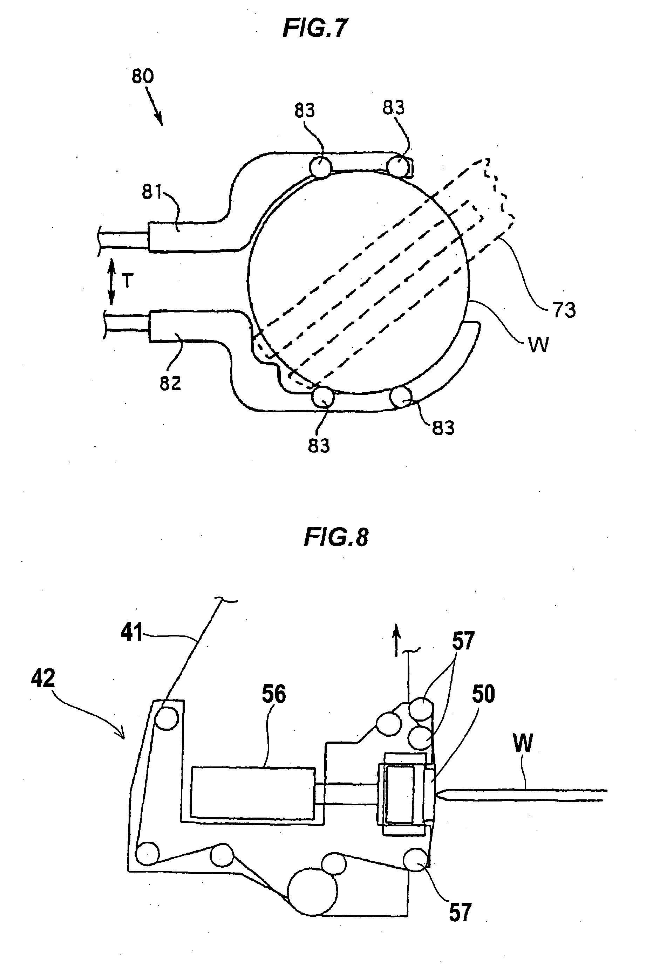

FIG. 7 is a plan view showing chuck hands of the wafer chucking mechanism 80. As shown in FIG 7, the wafer chucking mechanism 80 has a first chuck hand 81 having a plurality of pins 83 and a second chuck hand 82 having a plurality of pins 83. These first chuck hand 81 and second chuck hand 82 are moved closer to and away from each other (as indicated by arrows T) by an opening and closing mechanism (not shown). Further, the first chuck hand 81 and the second chuck hand 82 are moved in a direction perpendicular to the surface of the wafer W held by the wafer stage 23 by a chuck moving mechanism (not shown).

A hand 73 of the wafer transporting mechanism transports the wafer W to a position between the first chuck hand 81 and the second chuck hand 82. When the first chuck hand 81 and the second chuck hand 82 are moved closer to each other, the pins 83 are brought into contact with the periphery of the wafer W, whereby the wafer W is held by the first chuck hand 81 and the second chuck hand 82. A center of the wafer W when held by the chuck hands 81 and 82 and a center of the wafer stage 23 (i.e., a rotational axis of the wafer stage 23) agree with each other. Therefore, the first chuck hand 81 and the second chuck hand 82 also function as a centering mechanism.

As shown in FIG 6, the stage moving mechanism 30 includes a cylindrical bearing base 29 configured to rotatably support the hollow shaft 27, a support plate 32 to which the bearing base 29 is secured, a movable plate 33 which is movable together with the support plate 32, a ball screw b2 coupled to the movable plate 33, and a motor m2 configured to rotate the ball screw b2. The movable plate 33 is coupled to a lower surface of the partition plate 14 via linear guides 35 that allow the movable plate 33 to move in a direction parallel to the upper surface of the wafer stage 23. The bearing base 29 extends through a through-hole 17 of the partition plate 14. The above-mentioned motor m1 for rotating the hollow shaft 27 is secured to the support plate 32.

In these configurations, when the ball screw b2 is rotated by the motor m2, the movable plate 33, the bearing base 29, and the hollow shaft 27 move in the longitudinal direction of the linear guides 35 to allow the wafer stage 23 to move in the direction parallel to the upper surface of the wafer stage 23. In FIG 6, the moving direction of the wafer stage 23 by the stage moving mechanism 30 is indicated by arrows X.

As shown in FIG 6, the bevel polishing unit 40 includes a polishing head 42 configured to press a polishing tape (a belt-shaped polishing tool) 41 against the bevel portion of the wafer W, and a tape feeding mechanism 45 configured to feed the polishing tape 41 to the polishing head 42. The tape feeding mechanism 45 includes a feed roller 45a for feeding the polishing tape 41 to the polishing head 42, a take-up roller 45b for winding the polishing tape 41 that has been supplied to the polishing head 42, and a rotating mechanism (not shown) for rotating the take-up roller 45b. The polishing head 42 lies in the same plane as the wafer W held on the wafer stage 23.

When the rotating mechanism rotates the take-up roller 45b, the polishing tape 41 is fed to the polishing head 42 from the feed roller 45a. The polishing tape 41 travels in a direction perpendicular to the surface of the wafer W held by the wafer stage 23 and is wound on the take-up roller 45b.

The polishing tape 41 can be constituted by a base film and abrasive particles, such as diamond particles or SiC particles, bonded to one-side surface of the base film. This surface with the abrasive particles provides the polishing surface. The abrasive particles to be bonded to the polishing tape 41 are selected according to a type of wafer W and a required capability. Examples of the abrasive particles to be used include diamond particles and SiC particles having an average diameter ranging from 0.1 µm to 5.0 µm. A belt-shaped polishing cloth with no abrasive particles can also be used. The base film may be a film made from a flexible material, such as polyester, polyurethane, or polyethylene terephthalate.

FIG. 8 is an enlarged view of the polishing head 42. As shown in FIG. 8, the polishing head 42 includes a press pad 50 disposed at the rear side of the polishing tape 41, a pressing mechanism (i.e., an air cylinder) 56 coupled to the press pad 50, and a plurality of guide rollers 57 guiding the traveling direction of the polishing tape 41 to a direction perpendicular to the surface of the wafer W. The pressing mechanism 56 is configured to move the press pad 50 toward the wafer W to thereby cause the press pad 50 to press the polishing surface of the polishing tape 41 against the bevel portion of the wafer W. As shown in FIG. 6, polishing liquid supply nozzles 58 are disposed above and below the wafer W, respectively, so that a polishing liquid, cooling water, and the like are supplied onto a contact region between the wafer W and the polishing tape 41.

Next, operation of the polishing apparatus thus constructed will be described. The wafer W is transported into the housing 11 through the opening 12 by the wafer transporting mechanism (not shown). The wafer chucking mechanism 80 receives the wafer W from the hands 73 (see FIG 7) of the wafer transporting mechanism and grasps the wafer W with the first and second chuck hands 81 and 82. After transporting the wafer W to the first and second chuck hands 81 and 82, the hands 73 of the wafer transporting mechanism move outside the housing 11 and then the shutter 13 is closed. The wafer chucking mechanism 80 holding the wafer W lowers the wafer W and places the wafer W onto the upper surface of the wafer stage 23. Then, the vacuum pump (not shown) is set in motion to attract the wafer to the upper surface of the wafer stage 23.

Thereafter, the wafer stage 23, together with the wafer W, is moved closer to the polishing head 42 by the stage moving mechanism 30. Subsequently, the wafer stage 23 is rotated by the motor m1 and then, supply of the polishing liquid onto the wafer W from the polishing liquid supply nozzles 58 is started. When a rotational speed of the wafer W and a flow rate of the polishing liquid reach predetermined values, the stage moving mechanism 30 moves the wafer W to bring the wafer W into contact with the polishing tape 41. At this time, the press pad 50 projects toward the wafer W by the pressing mechanism 56. The wafer W is moved by the stage moving mechanism 30 to a position where the bevel portion of the wafer W pushes back the press pad 50 and a pressing force of the pressing mechanism 56 acts on the bevel portion of the wafer W, whereby the polishing surface of the polishing tape 41 is pressed against the bevel portion of the wafer W. In this manner, the bevel portion of the wafer W is polished.

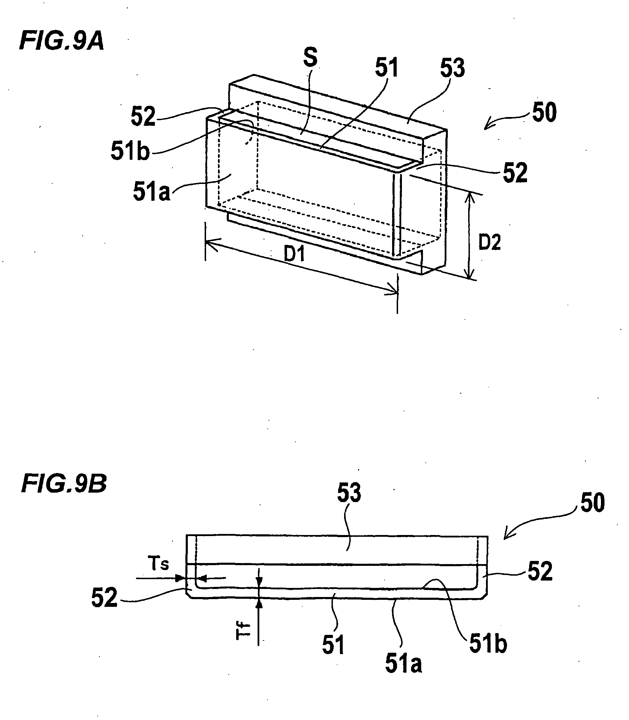

Next, the press pad 50 incorporated in the aforementioned polishing head 42 will be described in detail. FIG. 9A is a perspective view showing the press pad 50 incorporated in the polishing head 42 shown in FIG 8, and FIG 9B is a top view of the press pad 50 shown in FIG 9A.

As shown in FIGS. 9A and 9B, the press pad 50 has a plate-shaped pressing section 51 having a flat pressing surface 51a, two coupling sections 52 connected to both sides of the pressing section 51, and a pad body 53 to which these coupling sections 52 are secured. The pressing surface 51a has a rectangular shape, and a width (i.e., a dimension along a circumferential direction of the wafer W) D1 thereof is larger than a height (i.e., a dimension along a direction perpendicular to the surface of the wafer W) D2 thereof. In the present embodiment, a thickness Tf of the pressing section 51 and a thickness Ts of the coupling sections 52 are about 0.5 mm. The pressing section 51, the coupling sections 52, and the pad body 53 are integrally formed. The press pad 50 is made from rigid plastic (rigid resin), such as PVC (polyvinyl chloride). Use of such material allows the pressing section 51 to function as an elastic element having flexibility like a flat spring.

The pressing surface 51a is arranged so as to face the bevel portion of the wafer W held by the wafer stage 23 (see FIG 6). The coupling sections 52 are perpendicular to the pressing surface 51 a and also perpendicular to the surface of the wafer W. Further, the two coupling sections 52 are arranged along the circumferential direction of the wafer W. There is a space S between a rear surface 51b of the pressing section 51 and the pad body 53. Specifically, the pressing section 5-1 is coupled to the pad body 53 only by the two coupling sections 52.

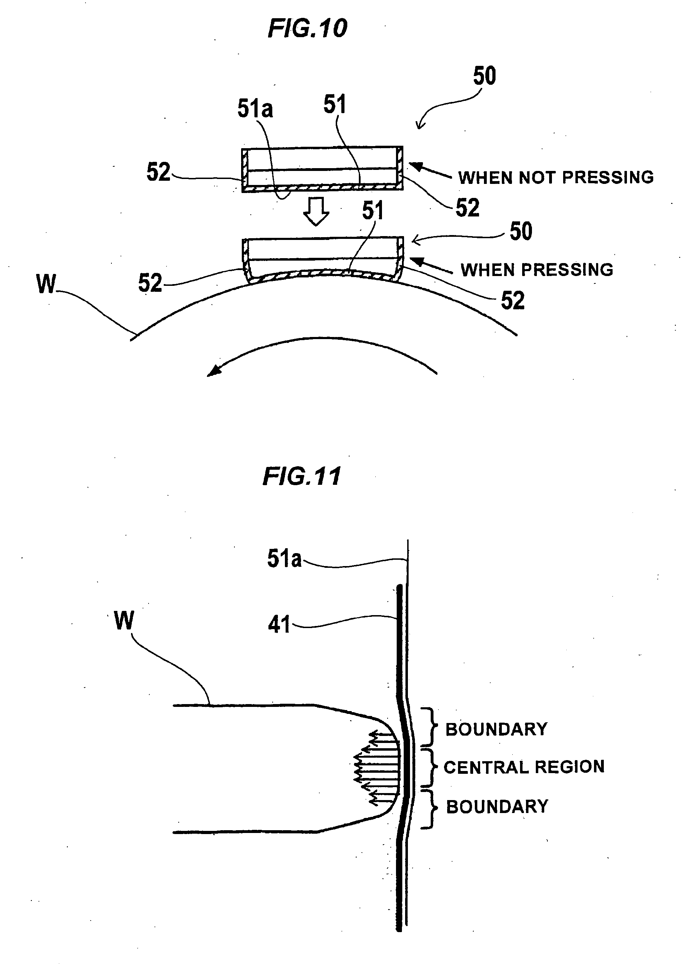

FIG 10 is a plan view showing the press pad when pressing the wafer and when not pressing the wafer. The polishing tape 41 is not shown in FIG 10. As shown in FIG 10, when the press pad 50 is away from the wafer W, the pressing section 51 maintains its shape as it is, and the pressing surface 51a is flat. On the other hand, when the press pad 50 presses the wafer W, the pressing section 51 is bent along the circumferential direction of the wafer W. The two coupling sections 52 are also bent toward a center of the pressing section 51. Each coupling section 52 also has a plate shape and functions as an elastic element having flexibility like a flat spring.

Since the pressing section 51 and the coupling sections 52 are deformed (bent) in this manner, the pressing surface 51a contacts the bevel portion of the wafer W over an entire length of the pressing surface 51a. Therefore, a contact length between the wafer W and the polishing tape 41 becomes longer, compared with a conventional press pad shown in FIG 2. This contact length can be changed by the pressing force applied to the wafer W from the press pad 50, the thickness Tf of the pressing section 51, and the thickness Ts of the coupling sections 52.

FIG 11 is a vertical cross-sectional view showing the press pad 50 when pressing the polishing tape 41 against the bevel portion of the wafer W. Because the pressing section 51 is made from rigid plastic, the pressing surface 51a is less likely to be compressed when contacting the bevel portion, compared with a case of pressing the polishing tape with a conventional press pad made from sponge or rubber. That is, the rigidity of the pressing section 51 can prevent the pressing surface 51a from following the shape of the wafer W in the direction perpendicular to the surface of the wafer W. As a result, polishing pressure applied to the wafer W increases at the central region of the bevel portion. Therefore, the central region of the bevel portion can be polished well.

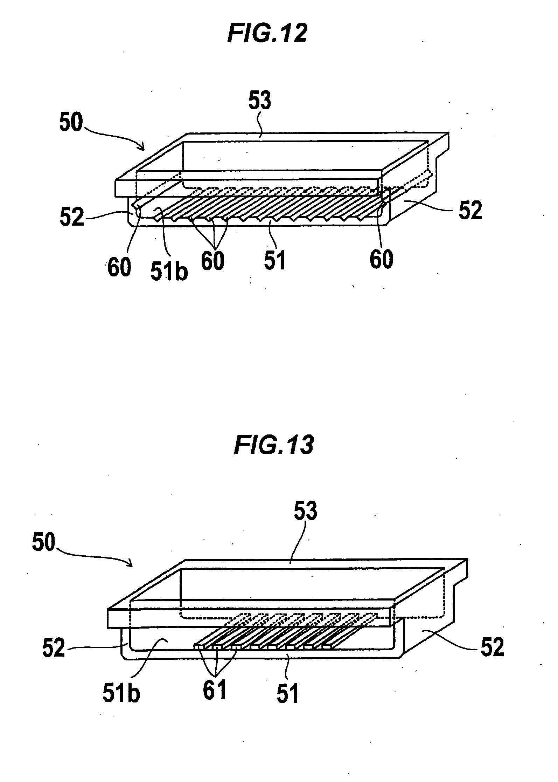

FIG 12 is a plan view showing another example of the press pad 50. Structures of the press pad, which will not be described particularly, are identical to those of the press pad shown in FIGS. 9A and 9B, and repetitive explanations are omitted. In this example, a plurality of grooves 60, extending in a direction perpendicular to the surface of the wafer W held on the wafer stage 23 (see FIG 6), are formed on the rear surface 51b of the pressing section 51. These grooves are arranged in parallel to each other at equal intervals and each groove has a triangular cross section. Similarly, a groove 60, extending in the direction perpendicular to the surface of the wafer W, is formed on an inner surface of each coupling section 52.

These grooves 60 serve to enable controlling of a curvature of the pressing section 51 when bent along the circumferential direction of the wafer W, and also serve to enhance the flexural rigidity of the pressing section 51 in the direction perpendicular to the surface of the wafer W. Therefore, the pressing section 51 is not compressed greatly along the vertical cross-sectional shape of the bevel portion of the wafer W, and the pressing section 51 can press the bevel portion with the flatter pressing surface 51a. The flexural strength in the circumferential direction and the vertical direction of the wafer W can be adjusted by modifying depth, shape, and the number of grooves 60 to be formed. Therefore, the press pad 50 is able to have optimum elasticity for polishing the bevel portion.

FIG 13 is a perspective view showing another example of the press pad 50. Structures of the press pad, which will not be described particularly, are identical to those of the press pad shown in FIGS. 9A and 9B, and repetitive explanations are omitted. In this example, a plurality of reinforcing plates (reinforcing members) 61, extending in a direction perpendicular to the surface of the wafer W held on the wafer stage 23 (see FIG 6), are secured to the rear surface 51b of the pressing section 51. These reinforcing plates 61 are located near the center to the pressing section 51.

These reinforcing plates 61 serve to enable controlling of a curvature of the pressing section 51 when bent along the circumferential direction of the wafer W, and also serve to enhance the flexural rigidity of the pressing section 51 in the direction perpendicular to the surface of the wafer W. Therefore, the pressing section 51 is not compressed greatly along the shape of the bevel portion of the wafer W, and the pressing section 51 can press the bevel portion with the flatter pressing surface 51 a. The flexural strength in the circumferential direction and the vertical direction of the wafer W can be adjusted by modifying thickness, material, number, and arrangement of the reinforcing plates 61 to be provided. Therefore, the press pad 50 is able to have optimum elasticity for polishing the bevel portion.

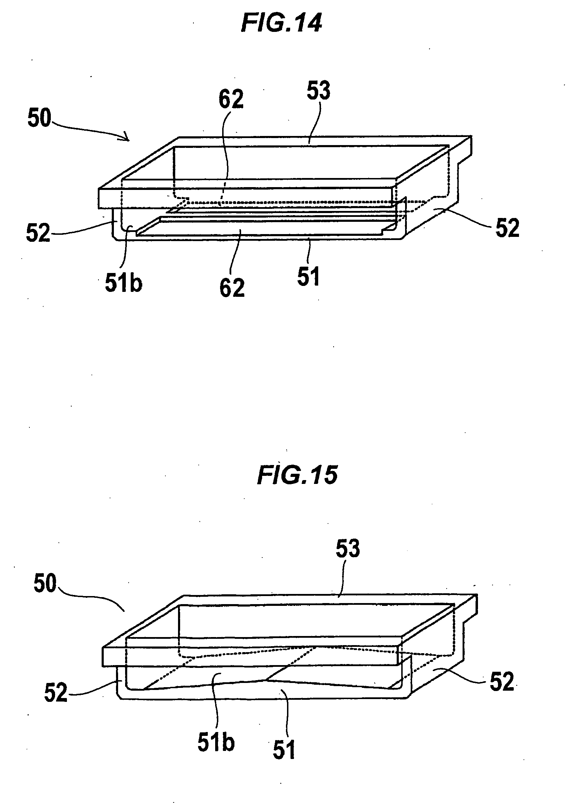

FIG 14 is a perspective view showing another example of the press pad 50. Structures of the press pad, which will not be described particularly, are identical to those of the press pad shown in FIGS. 9A and 9B, and repetitive explanations are omitted. In this example, two recesses 62, extending in the circumferential direction of the wafer W held on the wafer stage 23 (see FIG 6), are formed on the rear surface 51b of the pressing section 51. No recess is formed at a rear side of the portion to be brought into contact with the bevel portion of the wafer W. Specifically, the pressing section 51 has its original thickness at a region between the above-described two recesses 62.

These recesses 62 serve to enable controlling of a curvature of the pressing section 51 when bent along the circumferential direction of the wafer W, and also serve to enhance the flexural rigidity of the pressing section 51 in the direction perpendicular to the surface of the wafer W. Therefore, the pressing section 51 is not compressed greatly along the shape of the bevel portion of the wafer W, and the pressing section 51 can press the bevel portion with the flatter pressing surface 51a. The press pad 50 is able to have optimum elasticity for polishing the bevel portion by modifying shape, number, and arrangement of the recesses 62 to be formed.

FIG 15 is a perspective view showing another example of the press pad 50. Structures of the press pad, which will not be described particularly, are identical to those of the press pad shown in FIGS. 9A and 9B, and repetitive explanations are omitted. In this example, the rear surface 51b of the pressing section 51 slopes toward the center of the rear surface 51b from both sides thereof such that the thickness of the pressing section 51 increases linearly from the both sides to the center of the pressing section 51. This configuration serves to enable controlling of a curvature of the pressing section 51 when bent along the circumferential direction of the wafer W, and also serve to enhance the flexural rigidity of the pressing section 51 in the direction perpendicular to the surface of the wafer W. Therefore, the pressing section 51 is not compressed greatly along the shape of the bevel portion of the wafer W and the pressing section 51 can press the bevel portion with the flatter pressing surface 51 a.

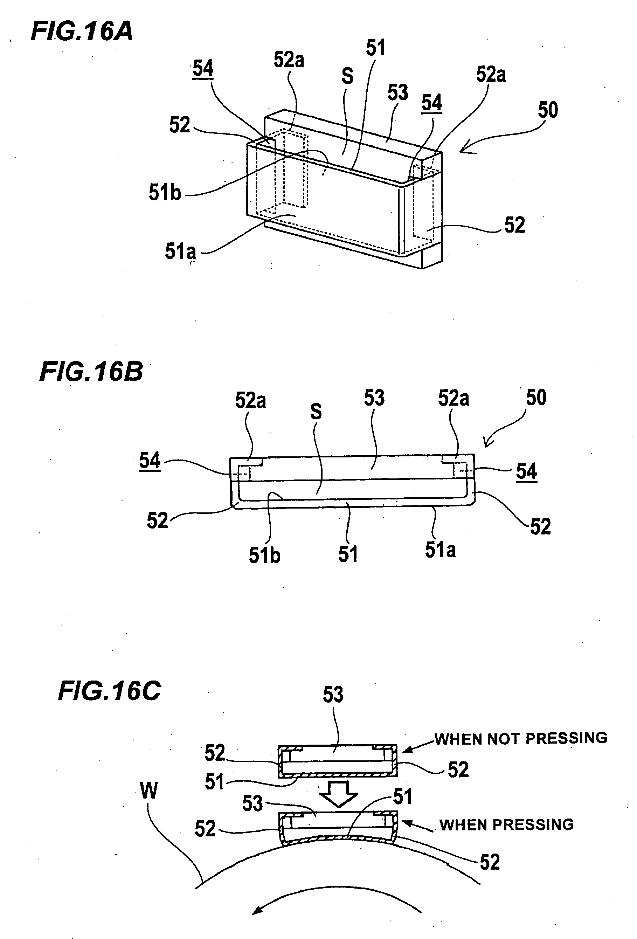

FIG 16A is a perspective view showing another example of the press pad 50, FIG 16B is a top view of the press pad 50 shown in FIG 16A, and FIG. 16C is a plan view showing the press pad when pressing the wafer and when not pressing the wafer. Structures of the press pad, which will not be described particularly, are identical to those of the press pad shown in FIGS. 9A and 9B, and repetitive explanations are omitted.

In this example, the pressing section 51 and the two coupling sections 52 are integrally formed, but the pad body 53 is provided as a separate member. The pressing section 51 and the two coupling sections 52 are made from rigid plastic (rigid resin), such as PVC (polyvinyl chloride). The pad body 53 is made from the same material. Edges of the respective coupling sections 52 have folded portions 52a extending inwardly, and these folded portions 52a and a rear surface of the pad body 53 are secured to each other with glue or the like.

The pad body 53 has substantially an H-shape as viewed from its front and there are clearances 54 between side surfaces of the pad body 53 and the coupling sections 52. By providing these clearances 54, the coupling sections 52 are not brought into contact with the pad body 53 when the coupling sections 52 are bent inwardly, as shown in FIG. 16C. Therefore, the pad body 53 does not interfere with the coupling sections 52 when they are bent inwardly. Further, the clearances 54 can reduce a shear force acting on junctions between the pad body 53 and the coupling sections 52 when the coupling sections 52 are bent inwardly.

The pressing section 51 and the two coupling sections 52 may be made from a different material from the pad body 53. For example, the pressing section 51 and the two coupling sections 52 may be integrally formed by using a special material, such as engineering plastic, and the pad body 53 may be made from another low-cost material. These configurations make it possible to reduce a production cost. Further, the coupling sections 52 and the pad body 53 may be joined to each other with an adhesive tape, so that the pressing section 51 and the coupling sections 52 can be replaceable.

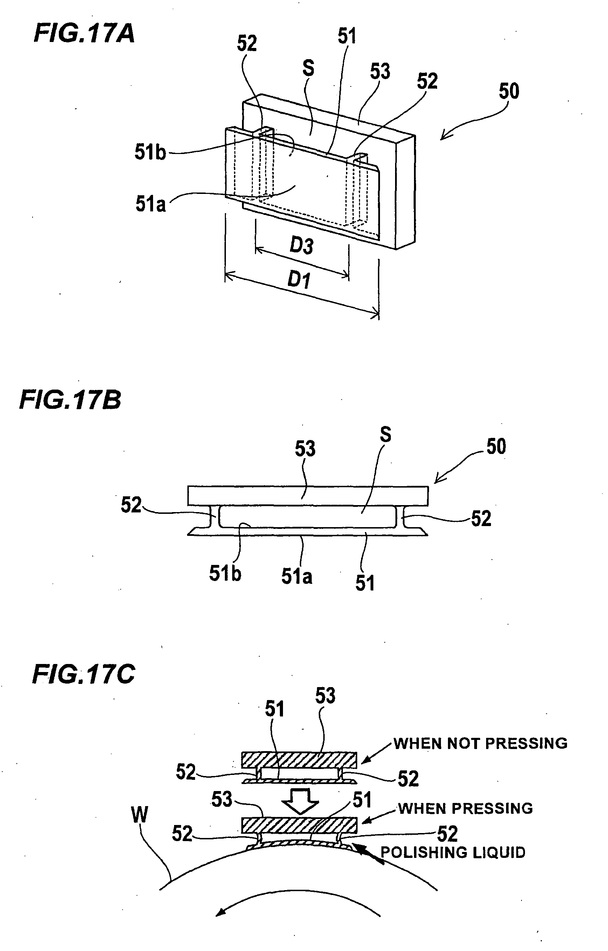

FIG 17A is a perspective view showing another example of the press pad 50, FIG 17B is a top view of the press pad 50 shown in FIG. 17A, and FIG 17C is a plan view showing the press pad when pressing the wafer and when not pressing the wafer. Structures of the press pad, which will not be described particularly, are identical to those of the press pad shown in FIGS. 9A and 9B, and repetitive explanations are omitted. In this example, the two coupling sections 52 are connected to the rear surface 51b of the pressing section 51. These coupling sections 52 are located inwardly from both sides of the pressing section 51 toward the center thereof. Specifically, a distance D3 between the coupling sections 52 is smaller than the width D 1 of the pressing section 51.

The press pad 50 thus constructed has the following advantages. As discussed above, the polishing liquid is supplied to the wafer W during polishing. This polishing liquid scatters from the wafer W due to the rotation of the wafer W, as shown in FIG 17C. In the case where the coupling sections 52 are disposed on both sides of the pressing section 51, the polishing liquid, scattering from the wafer W, is likely to impinge upon the coupling sections 52 and bounce back onto the wafer W. According to the configuration shown in FIGS. 17A through 17C, since the coupling sections 52 are located inwardly from the both sides of the pressing section 51, the polishing liquid enters the rear side of the pressing section 51 and does not scatter onto the wafer W again. Therefore, this configuration can prevent the polishing liquid from contacting again a region where devices are formed and can protect the devices from contamination.

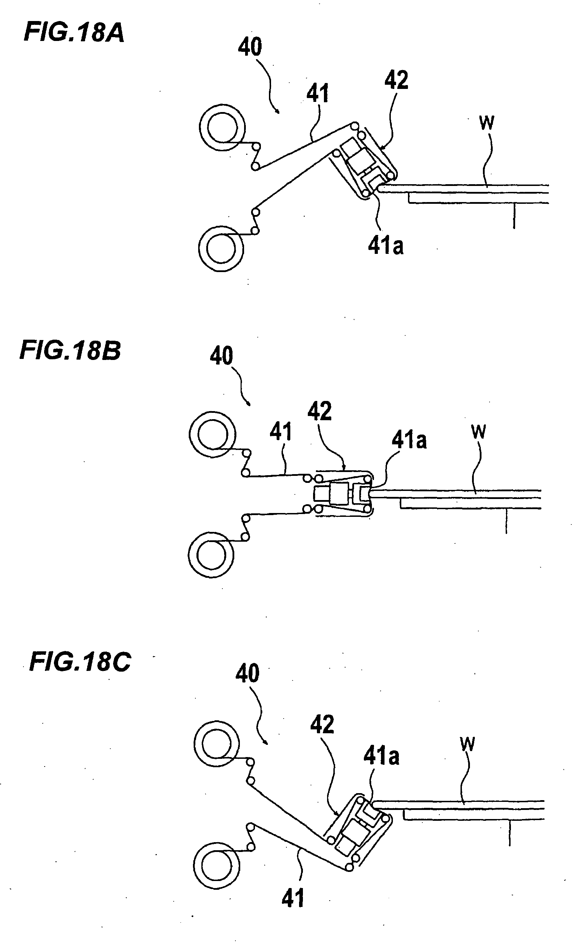

FIGS. 18A through 18C are views for explaining operation of the polishing head 42 during bevel polishing. The bevel polishing unit 40 includes an oscillating mechanism (not shown) configured to oscillate the polishing head 42 upwardly and downwardly with a center of the oscillation lying on the polishing position of the bevel portion of the wafer W. This oscillating mechanism allows the polishing head 42 to bring the polishing surface 41a of the polishing tape 41 into contact with the bevel portion, with the polishing head 42 being inclined upwardly or downwardly at a predetermined angle with respect to the surface of the wafer W. Therefore, as shown in FIG, 18A, the upper slope surface of the bevel portion can be polished by the polishing head 42 inclined downwardly at a predetermined angle with respect to the surface of the wafer W. As shown in FIG 18B, the side surface of the bevel portion can be polished by the polishing head 42 facing in the horizontal direction. As shown in FIG 18C, the lower slope surface of the bevel portion can be polished by the polishing head 42 inclined upwardly at a predetermined angle with respect to the surface of the wafer W. Further, by making fine adjustments to the angle of inclination of the polishing head 42, the upper and lower slope surfaces, the side surface, and boundaries therebetween of the bevel portion can be polished to desired angles and desired shapes.

When the polishing head 42 is oscillated in the vertical direction around the polishing position of the bevel portion of the wafer W, a contact condition between the wafer W and the polishing tape 41 changes according to a position of the oscillating polishing head 42. Specifically, a shape, a contact area, and a pressure distribution of the press pad 50 when contacting the wafer W through the polishing tape 41 vary.

In FIG 10, FIG 16C, and FIG 17C, the polishing head 42 is located such that the polishing tape 41 contacts the side surface of the wafer W in the perpendicular direction, as shown in FIG 18B. In this state, the press pad 50 is deformed along the circumference of the wafer W. On the other hand, as shown in FIGS. 18A and 18C, when the polishing head 42 is inclined at such angles as to polish the upper and lower slope surfaces of the bevel portion, the shape, the contact area, and the pressure distribution of the press pad 50 in contact with the wafer W vary in a complicated manner. Therefore, it is preferable to select the shape of the press pad 50 on consideration of the variations in the shape, the contact area, and the pressure distribution of the press pad 50 with the change in the polishing angle of the polishing head 42.

In the polishing apparatus shown in FIG. 5, it is possible to provide a plurality of polishing heads 42 inside the apparatus. Further, it is also possible to provide multiple polishing heads, one of which has a conventional press pad constituted by only an elastic material and the other has the press pad according to the present invention. In this manner, it is possible to use the press pad selectively. Further, it is also possible to select type of press pad from the above-described examples and use the selected press pad in one or more of the multiple polishing heads.

### Industrial Applicability

The present invention is applicable to a polishing apparatus for polishing a bevel portion of a substrate, such as a semiconductor wafer.

## Claims

1. A polishing apparatus comprising:
a polishing tape having a polishing surface;
a substrate holder configured to hold and rotate a substrate;
a press pad configured to press the polishing tape against a bevel portion of the substrate held by said substrate holder; and
a polishing-tape feeding mechanism configured to cause the polishing tape to travel in its longitudinal direction,
wherein said press pad includes
a pad body,
a plate-shaped pressing section having a pressing surface for pressing the bevel portion of the substrate through the polishing tape and having a rear surface opposite to said pressing surface, and
a plurality of coupling sections coupling said pressing section to said pad body, and
wherein a space is formed between said rear surface of said pressing section and said pad body.

2. The polishing apparatus according to claim 1, wherein said plurality of coupling sections are arranged along a circumferential direction of the substrate held by said substrate holder.

3. The polishing apparatus according to claim 1, wherein said plurality of coupling sections are connected to both sides of said pressing section.

4. The polishing apparatus according to claim 1, wherein said plurality of coupling sections are connected to said rear surface of said pressing section and located inwardly from both sides of said pressing section toward a center of said pressing section.

5. The polishing apparatus according to claim 1, wherein said rear surface of said pressing section has a plurality of grooves extending in a direction perpendicular to a surface of the substrate.

6. The polishing apparatus according to claim 1, wherein a plurality of reinforcing members, extending in a direction perpendicular to a surface of the substrate, are secured to said rear surface of said pressing section.

7. The polishing apparatus according to claim 1, wherein said rear surface of said pressing section has at least one recess extending in a circumferential direction of the substrate.

8. The polishing apparatus according to claim 1, wherein said pressing section has a shape such that a thickness thereof increases gradually from both sides of said pressing section toward a center thereof.

9. The polishing apparatus according to claim 1, wherein said pressing section is made from rigid plastic.
